# EUROPÄISCHE PATENTSCHRIFT

(11) **EP 2 717 659 B1**
(45) Veröffentlichungstag und Bekanntmachung des Hinweises auf die Patenterteilung: **02.01.2019**
(21) Anmeldenummer: 13184932.5
(22) Anmeldetag: 18.09.2013
(51) Int. Cl.: H05K 5/00, H05K 7/20

(54) **Verfahren zur Herstellung eines Steuergerätes**
Method for producing a control device
Procédé de fabrication d'un appareil de commande

(30) Priorität: 08.10.2012 DE 102012218307
(43) Veröffentlichungstag der Anmeldung: 09.04.2014
(73) Patentinhaber: ROBERT BOSCH GMBH, 70442 Stuttgart (DE)
(72) Erfinder: Braunger, Joachim, 74374 Zaberfeld (DE); Pfeiffer, Peter, 71638 Ludwigsburg (DE); Eckmann, Philipp, 71254 Ditzingen (DE); Becker, Ulrich, 75223 Niefern-Oeschelbronn (DE); Beckbissinger, Kai, 70569 Stuttgart (DE); Weber, Bernd, 74232 Abstatt (DE); Gebers, Joerg, 71282 Hemmingen (DE)

(56) Entgegenhaltungen:
- EP-A2- 2 071 911
- DE-A1- 4 422 114
- DE-A1-102008 040 501
- US-A1- 2006 082 975

## Beschreibung

### Stand der Technik

Die vorliegende Erfindung betrifft ein Verfahren zur Herstellung eines Steuergerätes. Das Steuergerät wird insbesondere in Kraftfahrzeugen verwendet.

Die Druckschrift DE 10 2008 040 501 A1 zeigt ein herkömmliches Steuergerät. Das Steuergerät umfasst ein Gehäuse in dem eine elektronische Baugruppe eingeschoben ist. Die elektronische Baugruppe umfasst eine Leiterplatte. Die Leiterplatte wird in gegenüberliegenden Nuten im Gehäuse aufgenommen. Im Bereich der Nuten bedarf es einer gut wärmeleitenden Kontaktierung zwischen der Leiterplatte und dem Gehäuse zum Abführen von Wärme. Die Wärme entsteht insbesondere in elektrischen Bauteilen, die auf der Leiterplatte montiert sind.

### Offenbarung der Erfindung

Das erfindungsgemäße Verfahren zur Herstellung eines Steuergerätes mit den Merkmalen des Anspruchs 1 ermöglicht eine gleichmäßige und prozesssichere Einbringung eines flüssigen Wärmeleitmediums in einen Spalt zwischen Gehäuse und elektronischer Baugruppe. Dadurch kann ein sicherer Wärmeübergang von der elektronischen Baugruppe auf das Gehäuse auch bei Verwendung der Einschubtechnik gewährleistet werden. Dies hat zur Folge, dass das Einschieben der elektronischen Baugruppe in das Gehäuse, bei sehr vielen Einsatzmöglichkeiten genutzt werden kann. Diese Vorteile werden erreicht durch folgende Verfahrensschritte: (i) Bereitstellen eines Gehäuses, wobei in dem Gehäuse zumindest eine Nut mit zwei gegenüberliegenden Nutwandungen ausgebildet ist. Insbesondere sind in dem Gehäuse zwei Nuten vorgesehen. (ii) Einschieben einer elektronischen Baugruppe in das Gehäuse. Die elektronische Baugruppe greift dabei, zumindest teilweise, in die Nut ein, so dass die elektronische Baugruppe mittels der Nuten in dem Gehäuse positioniert ist. Die elektronische Baugruppe umfasst insbesondere eine Leiterplatte, wobei die Leiterplatte in die Nut eingreift. Insbesondere ist die Leiterplatte beidseitig durch je eine Nut im Gehäuse geführt. Der Abstand zwischen den beiden gegenüberliegenden Nutwandungen ist etwas größer als die Dicke der Leiterplatte, so dass zwischen einer der Nutwandungen und der elektronischen Baugruppe ein Spalt entsteht. Über diesen Spalt muss die Wärme von der elektronischen Baugruppe in das Gehäuse abgeführt werden. Deshalb wird in dem erfindungsgemäßen Verfahren der Spalt mit einem Wärmeleitmedium ausgefüllt. (iii) In dem Verfahren erfolgt ein Positionieren eines flüssigen Wärmemediums außerhalb des Spaltes, jedoch im Inneren des Gehäuses. (iv) In einem weiteren Schritt erfolgt das Einbringen des positionierten Wärmeleitmediums in den Spalt. Dies erfolgt durch Kippen und/oder Bewegen des Gehäuses inklusive der eingeschobenen elektronischen Baugruppe. Durch das Kippen und/oder Bewegen fließt das Wärmeleitmedium in den Spalt. Zusätzlich oder alternativ dazu kann das Gehäuse auch lediglich so gekippt werden, dass das positionierte Wärmeleitmedium am Rande des Spaltes anliegt. Die Spaltweite ist in Abhängigkeit der Viskosität des Wärmeleitmediums derart ausgestaltet, so dass durch eine Kapillarwirkung das flüssige Wärmeleitmedium in den Spalt hineingezogen wird. Nach dem Einbringen des Wärmeleitmediums in den Spalt, härtet das Wärmeleitmedium aus, oder wird zumindest zähflüssig, so dass ein bleibender, thermisch leitender Kontakt zwischen der elektronischen Baugruppe und dem Gehäuse sicher gestellt ist. Der oben erwähnte Schritt "Positionieren des flüssigen Wärmeleitmediums" kann nach oder vor dem Einschieben der elektronischen Baugruppe erfolgen. Ausschlaggebend ist, dass das Wärmeleitmedium in ausreichender Menge zunächst außerhalb des Spaltes positioniert wird. Erst nachdem sich die elektronische Baugruppe, insbesondere die Leiterplatte, an gewünschter Position im Gehäuse befindet, erfolgt das Einbringen des Wärmeleitmediums in den Spalt. Erfindungsgemäß bedarf es also keiner besonderen Öffnungen im Gehäuse, um nach dem Einschieben der elektronischen Baugruppe das Wärmeleitmedium in den Spalt einzuspritzen. Des Weiteren können erfindungsgemäß herkömmliche Leiterplatten verwendet werden, da das Wärmeleitmedium den Spalt gut füllt und keine "heatsinks" oder zusätzliche metallischen Körper zur Wärmeleitung und -spreizung benötigt werden.

Die Unteransprüche zeigen bevorzugte Weiterbildungen der Erfindung.

Bevorzugt ist vorgesehen, dass vor dem Einbringen in den Spalt und nach dem Positionieren des Wärmeleitmediums das Gehäuse fluiddicht verschlossen wird. Insbesondere umfasst die elektronische Baugruppe eine Leiterplatte und eine fest mit der Leiterplatte verbundene Steckerkulisse. Um die Steckerkulisse herum ist an der elektronischen Baugruppe ein Verschluss ausgebildet. Dadurch ist es möglich, dass gleichzeitig mit dem Einschieben der elektronischen Baugruppe in das Gehäuse der Verschluss das Gehäuse verschließt. Besonders bevorzugt wird zwischen dem Verschluss und dem Gehäuse eine Feststoffdichtung angeordnet. Nach dem Verschließen des Gehäuses befindet sich im erfindungsgemäßen Verfahren das Wärmeleitmedium im Inneren des Gehäuses, jedoch außerhalb des Spaltes. Erst im darauffolgenden Schritt erfolgt das Einbringen des Wärmeleitmediums in den Spalt.

Das Wärmeleitmedium kann innerhalb des Gehäuses an verschiedenen Positionen positioniert werden. Zum einen ist es möglich, das Wärmeleitmedium auf einer Innenfläche des Gehäuses zu positionieren. Zusätzlich oder alternativ dazu kann das Wärmeleitmedium auch auf der elektronischen Baugruppe, insbesondere auf der Leiterplatte, positioniert werden.

Wenn das Wärmeleitmedium auf der elektronischen Baugruppe positioniert wird, ist besonders bevorzugt vorgesehen, dass das Wärmeleitmedium schon vor dem Einschieben der elektronischen Baugruppe auf der elektronischen Baugruppe positioniert wird. Dadurch ist ein einfacher Montagevorgang gewährleistet.

Für den Schritt des Einbringens des Wärmeleitmediums in den Spalt sind verschiedene Möglichkeiten vorgesehen. Diese Möglichkeiten können auch miteinander kombiniert werden. Zunächst ist es möglich, das Wärmeleitmedium am Rande des Spaltes zu positionieren, oder durch ein Verkippen und/oder Bewegen des Gehäuses das Wärmeleitmedium an den Rand des Spaltes fließen zu lassen. Sobald das Wärmeleitmedium sich an dem Rand des Spaltes befindet, wird das Wärmeleitmedium durch die Kapillarwirkung in den Spalt hineingezogen. Zusätzlich oder alternativ zur Ausnutzung der Kapillarwirkung, kann das Gehäuse in Rotation versetzt werden. Durch die Zentrifugalkraft fließt das Wärmeleitmedium in den Spalt. Des Weiteren kann es ausreichen, das Gehäuse entsprechend zu kippen, so dass unter Ausnutzung der Schwerkraft das Wärmeleitmedium in den Spalt fließt. Des Weiteren ist es möglich, das Gehäuse linear zu beschleunigen, so dass das Wärmeleitmedium aufgrund der Trägheit in den Spalt fließt bzw. gedrückt wird.

Des Weiteren ist bevorzugt vorgesehen, zur Unterstützung der Einbringung des Wärmeleitmediums in den Spalt, die Viskosität des Wärmeleitmediums zu reduzieren. Zunächst kann das Wärmeleitmedium in einem vorgewärmten Zustand positioniert werden, so dass es eine ausreichend geringe Viskosität beim Einbringen aufweist. Zusätzlich oder alternativ dazu ist es möglich, nach dem Positionieren des Wärmeleitmediums, das Wärmeleitmedium direkt oder indirekt zu erwärmen, so dass sich dessen Viskosität weiter reduziert.

Zusätzlich oder alternativ zum Erwärmen des Wärmeleitmediums ist folgende Methode zur Reduktion der Viskosität vorgesehen: Bestimmte Wärmeleitmedien können durch eine mechanische Beanspruchung bzw. eine mechanische Scherbeanspruchung in ihrer Viskosität beeinflusst werden. Dies ist insbesondere bei thixotropen Medien der Fall. In diesem Fall ist insbesondere zur Reduktion der Viskosität des Wärmeleitmediums vorgesehen, das Gehäuse in Vibrationen zu versetzen, so dass das Wärmeleitmedium im Inneren des Gehäuses ebenfalls vibriert und sich dessen Viskosität reduziert.

Um eine definierte Spaltweite zu erhalten, sind insbesondere Abstandshalter im Spalt zwischen der elektronischen Baugruppe und der entsprechenden Nutwandung vorgesehen. Diese Abstandshalter können beispielsweise als Lötbumps ausgebildet sein. Die Lötbumps werden an der entsprechenden Fläche der Leiterplatte erzeugt. Zusätzlich oder alternativ zu den Lötbumps können die Abstandshalter auch durch separat eingebrachte Elemente, wie beispielsweise Glaskugeln als Füllstoff im Wärmeleitmedium, realisiert werden.

Nach dem Einbringen des Wärmeleitmediums in den Spalt erfolgt bevorzugt eine weitere Fixierung der elektronischen Baugruppe im Gehäuse. Hierzu ist insbesondere vorgesehen, dass im Bereich der Nut eine Prägung eingebracht wird. Durch die Prägung wird die elektronische Baugruppe, insbesondere die Leiterplatte, in der Nut fixiert. Um bei diesem Prägungsvorgang einen ausreichend großen Spalt zu gewährleisten, sind die oben genannten Abstandshalter von besonderem Vorteil. Ferner kann das Prägen auch vollständig oder teilweise vor dem Einbringen des Wärmeleitmediums erfolgen

Die Spaltweite, in die das Wärmeleitmedium eingebracht wird, liegt vorzugsweise im Bereich von 10 bis 500µm.

Das Gehäuse ist vorzugsweise aus Metall, insbesondere aus Aluminium gefertigt. Alternativ kann ein Kunststoffgehäuse mit partiellen Metalleinlagen im Bereich der Kühlbänke verwendet werden. Bevorzugt sind in dem Gehäuse und/oder an der elektronischen Baugruppe keine separaten Öffnungen vorgesehen, durch die ein Wärmeleitmedium nach Verschließen des Gehäuses in das Innere des Gehäuses eingebracht werden kann.

### Kurze Beschreibung der Zeichnungen

Nachfolgend werden Ausführungsbeispiele der Erfindung unter Bezugnahme auf die begleitende Zeichnung im Detail beschrieben. Dabei zeigen:
- Figur 1: eine Explosionsdarstellung eines Steuergerätes, hergestellt nach dem erfindungsgemäßen Verfahren gemäß dem Ausführungsbeispiel,
- Figur 2: den in Figur 1 gekennzeichneten Schnitt A-A,
- Figur 3: ein erstes Detail des erfindungsgemäßen Verfahrens gemäß dem Ausführungsbeispiel, und
- Figur 4: ein zweites Detail des erfindungsgemäßen Verfahrens gemäß dem Ausführungsbeispiel.

### Ausführungsform der Erfindung

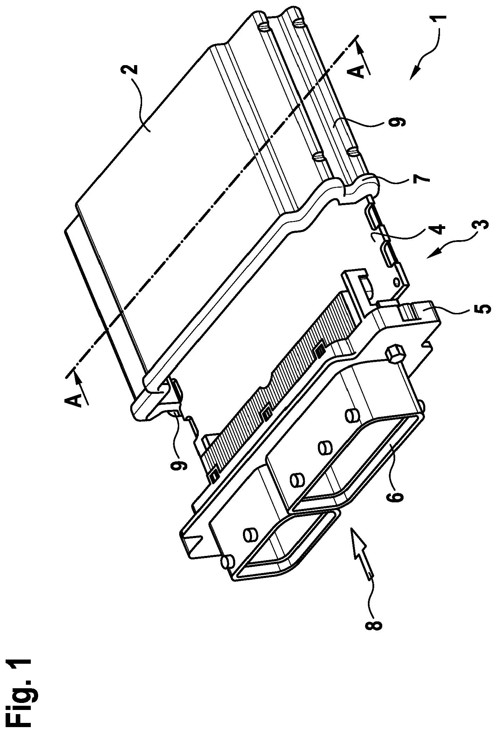

Nachfolgend wir anhand der Figuren 1 bis 4 ein Verfahren zur Herstellung eines Steuergerätes 1 im Detail beschrieben.

Das Steuergerät 1 umfasst ein Gehäuse 2. Das Gehäuse 2 ist auf einer Seite offen. Über diese offene Seite wird im erfindungsgemäßen Verfahren eine elektronische Baugruppe 3 in das Gehäuse eingeschoben. Die elektronische Baugruppe 3 umfasst eine Leiterplatte 4. Die Leiterplatte 4 ist fest verbunden und kontaktiert mit einer Steckerkulisse 6. Um die Steckerkulisse 6 herum ist ein Verschluss 5 ausgebildet.

Nachdem die elektronische Baugruppe 3 in Montagerichtung 8 vollständig in das Gehäuse 2 eingeschoben ist, verschießt der Verschluss 5 das Gehäuse 2. Zwischen dem Verschluss 5 und dem Gehäuse 2 ist eine umlaufende Feststoffdichtung 7 vorgesehen.

In dem Gehäuse 2 sind beidseitig Nuten 9 ausgebildet. Die elektronische Baugruppe 3 wird mit der Leiterplatte 4 in diese beiden Nuten eingeschoben.

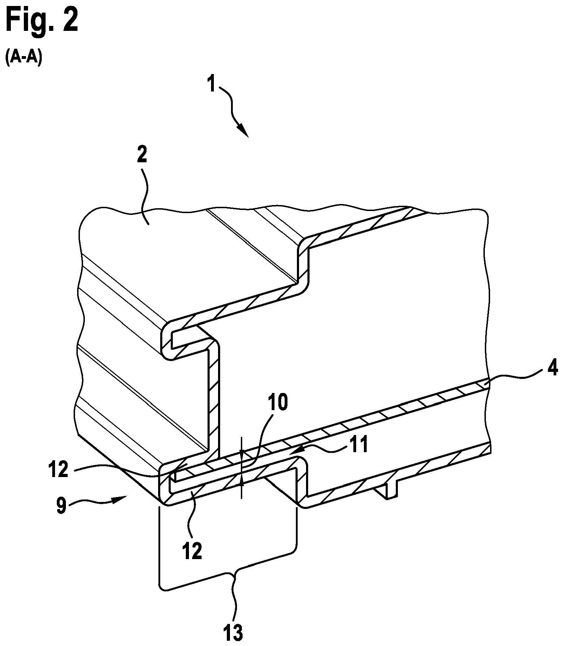

Figur 2 zeigt den in Figur 1 gekennzeichneten Schnitt A-A. Die Ansicht in Figur 2 zeigt eine der Nuten 9 mit eingeschobener Leiterplatte 4. Die Nut 9 ist unter anderem gebildet durch zwei gegenüberliegende Nutwandungen 12. Die Nutwandungen 12 sind im Gehäuse 2 ausgeformt.

In der Nut 9 steckt die Leiterplatte 4. Der Abstand zwischen den beiden gegenüberliegenden Nutwandungen 12 ist etwas größer als die Dicke der Leiterplatte 4, so dass in der Nut 9 ein Spalt 11 entsteht. Der Spalt 11 weist eine Spaltweite 10 auf. Die Spaltweite 10 wird als lichter Abstand zwischen der Leiterplatte 4 und einer der Nutwandungen 12 gemessen. Die nicht dargestellte, gegenüberliegende Seite des Gehäuses 2 ist symmetrisch zur gezeigten Seite ausgebildet.

Im Bereich der Nut 9 ist eine Kühlbank 13 im Gehäuse ausgebildet. Über diese Kühlbank soll die in der elektronischen Baugruppe 3 entstehende Wärme in das Gehäuse bzw. nach außen abgeführt werden. Deshalb bedarf es einer gut wärmeleitenden Verbindung zwischen der Leiterplatte 4 und der Kühlbank 13.

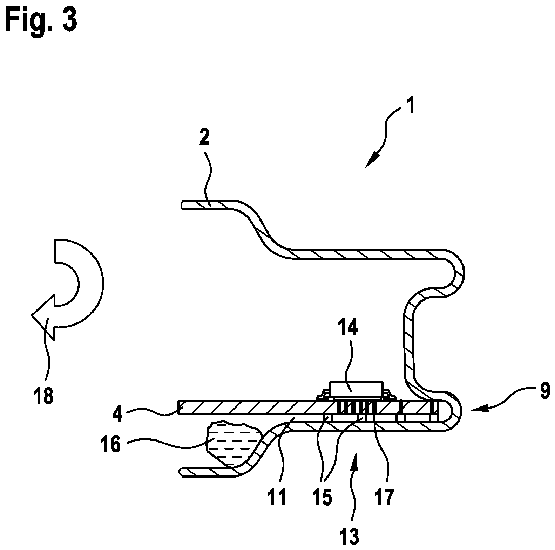

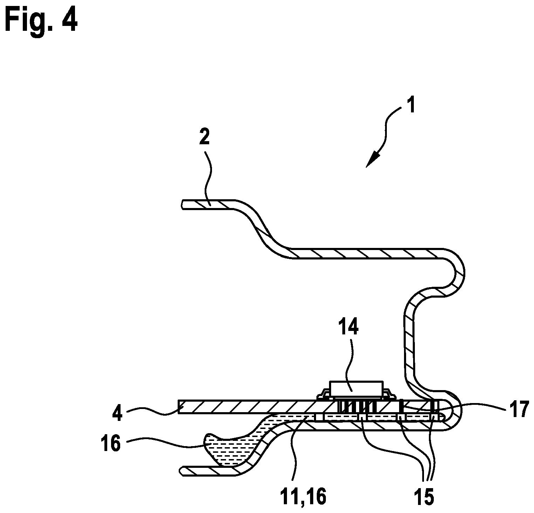

Dies wird durch Einbringen eines Wärmeleitmediums 16 (siehe Figuren 3 und 4) in den Spalt 11 erreicht.

Das Wärmeleitmedium 16 nach dem Einschieben der elektronischen Baugruppe 3 direkt in den Spalt 11 einzuspritzen ist im Verfahrensablauf sehr aufwendig und wird deshalb erfindungsgemäß nicht angewendet. Des Weiteren wäre es denkbar, das Wärmeleitmedium 16 vor dem Einschieben der Leiterplatte 4 direkt in den Spalt 11 einzubringen. Dies ist jedoch nachteilig, da beim Einschieben der Leiterplatte 4 in den Spalt 11 das Wärmeleitmedium 16 verdrängt wird und somit keine ausreichend genaue Verteilung des Wärmeleitmediums 16 im Spalt 11 gewährleistet ist.

Im Ablauf des erfindungsgemäßen Verfahrens wird das flüssige Wärmeleitmedium 16 außerhalb des Spaltes 11 positioniert und erst nach dem Einschieben der elektronischen Baugruppe 3 in den Spalt 11 eingebracht. Insbesondere erfolgt dieses Einbringen erst nach dem die elektronische Baugruppe 3 vollständig eingeschoben ist und somit auch der Verschluss 5 das Gehäuse 2 verschließt. Im Detail zeigen die Figuren 3 und 4 diesen Verfahrensablauf. Die Figuren 3 und 4 zeigen einen ähnlichen Schnitt wie Figur 2.

In Figur 3 ist die elektronische Baugruppe 3 bereits vollständig in das Gehäuse 2 eingeschoben. Das flüssige Wärmeleitmedium 16 ist außerhalb des Spaltes 11 auf einer Innenfläche des Gehäuses 2 positioniert. Insbesondere befindet sich im gezeigten Ausführungsbeispiel das Wärmeleitmedium 16 auf der Gehäuseinnenfläche unterhalb der Kühlbank 13. Nachdem die elektronische Baugruppe 3 vollständig in das Gehäuse 2 eingeschoben ist und somit auch der Verschluss 5 das Gehäuse 2 verschließt, wird das Steuergerät 1 in Rotation 18 versetzt. Durch diese Rotation 18 wird das Wärmeleitmedium 16 mit einer Zentrifugalkraft beaufschlagt, so dass das Wärmeleitmedium 16 in den Spalt 11 fließt. Im Spalt 11 dient das Wärmeleitmedium 16 als gut wärmeleitende Verbindung zwischen Leiterplatte 4 und Kühlbank 13.

Wie die Figuren 3 und 4 zeigen, sind auf der Leiterplatte 4, insbesondere im Bereich der Kühlbänke 13, elektrische Bauteile 14 montiert. Die Wärme dieser elektrischen Bauteile 14 muss über das Wärmeleitmedium 16 und die Kühlbänke 13 abgeführt werden. Hierzu ist insbesondere vorgesehen, dass von den elektrischen Bauteilen 14 durch die Leiterplatte 4 hindurch thermische Verbindungsbrücken 17 gesetzt sind. Diese thermischen Verbindungsbrücken 17 stehen im direkten Kontakt mit dem Wärmeleitmedium 16. Insbesondere bedarf es keiner "heatsinks" zwischen dem Wärmeleitmedium 16 und der Unterseite der Leiterplatte 4.

Nach dem Einbringen des Wärmeleitmediums 16 in den Spalt 11, wird die Leiterplatte 14 durch ein Prägen des Gehäuses 2 im Bereich der Nut 9 vollständig fixiert. Um hierbei eine ausreichende Spaltweite 10 zu gewährleisten, sind Abstandshalter 15 in dem Spalt 11 vorgesehen. Im gezeigten Ausführungsbeispiel sind die Abstandshalter 15 als Lötbumps auf der Leiterplatte 4 ausgebildet.

Zusätzlich oder ergänzend zur gezeigten Rotation 18 kann das Steuergerät auch lediglich geneigt oder linear beschleunigt werden, um somit ein Fließen des Wärmeleitmediums 16 in den Spalt 11 zu begünstigen. Zusätzlich oder alternativ dazu ist es auch möglich, dass das Steuergerät 1 lediglich so positioniert wird, so dass das Wärmeleitmedium 16 an den Rand des Spaltes 11 fließt und sodann durch die Kapillarwirkung in den Spalt 11 hineingezogen wird.

## Patentansprüche

1. Verfahren zur Herstellung eines Steuergerätes (1), umfassend die folgenden Schritte:
- Bereitstellen eines Gehäuses (2), wobei in dem Gehäuse (2) zumindest eine Nut (9) mit zwei gegenüberliegende Nutwandungen (12) ausgebildet ist,
- Einschieben einer elektronischen Baugruppe (3) in das Gehäuse (2), wobei die elektronische Baugruppe (3) zumindest teilweise in die Nut (9) eingeschoben wird, und wobei in der Nut (9) zwischen der elektronischen Baugruppe (3) und zumindest einer der Nutwandung (12) ein Spalt (11) verbleibt,
- Positionieren eines flüssigen Wärmeleitmediums (16) außerhalb des Spaltes (11) im Inneren des Gehäuses (2),
**dadurch gekennzeichnet, dass**
das Einbringen des Wärmeleitmediums (16) in den Spalt (11) durch Kippen und/oder Bewegen des Gehäuses (2) mit eingeschobener elektronischer Baugruppe (3) erfolgt, so dass das Wärmeleitmedium (16) in den Spalt (11) fließt und/oder durch Kapillarwirkung in den Spalt (11) gezogen wird.

2. Verfahren nach Anspruch 1, **dadurch gekennzeichnet, dass** vor dem Einbringen in den Spalt und nach dem Positionieren des Wärmeleitmediums (16) das Gehäuse (2) fluiddicht verschlossen wird.

3. Verfahren nach Anspruch 2, **dadurch gekennzeichnet, dass** die elektronische Baugruppe (3) einen Verschluss (5) mit integrierter Steckerkulisse (6) zum Verschließen des Gehäuses (2) umfasst.

4. Verfahren nach einem der vorhergehenden Ansprüche, **dadurch gekennzeichnet, dass** das Wärmeleitmedium (16) auf der elektronischen Baugruppe (3), insbesondere auf einer Leiterplatte (4) der elektronischen Baugruppe (3), positioniert wird.

5. Verfahren nach Anspruch 4, **dadurch gekennzeichnet, dass** das Wärmeleitmedium (16) auf der elektronischen Baugruppe (3), vordem Einschieben der elektronischen Baugruppe (3), positioniert wird.

6. Verfahren nach einem der vorhergehenden Ansprüche, **dadurch gekennzeichnet, dass** das Wärmeleitmedium (16) auf einer Innenfläche des Gehäuses (2) positioniert wird.

7. Verfahren nach einem der vorhergehenden Ansprüche, **dadurch gekennzeichnet, dass** das Gehäuse (2) zum Einbringen des Wärmeleitmediums (16) in den Spalt (11) gekippt wird, sodass das Wärmeleitmedium (16) aufgrund der Schwerkraft in den Spalt fließt und/oder in Rotation versetzt wird und/oder linear beschleunigt wird.

8. Verfahren nach einem der vorhergehenden Ansprüche, **dadurch gekennzeichnet, dass** die Viskosität des Wärmeleitmediums (16) während dem Einbringen durch Erwärmung und/oder Vibration des Gehäuses (2) reduziert wird.

9. Verfahren nach einem der vorhergehenden Ansprüche, **dadurch gekennzeichnet, dass** in dem Spalt (11) zumindest ein Abstandshalter (15) zwischen der elektronischen Baugruppe (3) und zumindest einer der Nutwandungen (12) positioniert wird.

10. Verfahren nach Anspruch 9, **dadurch gekennzeichnet, dass** die Abstandshalter (15) als Lötbumps auf der elektronischen Baugruppe (3) ausgebildet werden.

## Claims

1. Method for producing a control device (1), comprising the following steps:
- providing a housing (2), at least one groove (9) with two opposite groove walls (12) being formed in the housing (2),
- pushing an electronic assembly (3) into the housing (2), the electronic assembly (3) being at least partially pushed into the groove (9), and a gap (11) remaining in the groove (9) between the electronic assembly (3) and at least one of the groove walls (12),
- positioning a liquid heat conducting medium (16) outside the gap (11) in the interior of the housing (2),
**characterized in that**
the introduction of the heat conducting medium (16) into the gap (11) is performed by tilting and/or moving the housing (2) with the pushed-in electronic assembly (3), so that the heat conducting medium (16) flows into the gap (11) and/or is drawn into the gap (11) by capillary action.

2. Method according to Claim 1, **characterized in that** the housing (2) is sealed in a fluid-tight manner before the heat conducting medium (16) is introduced into the gap and after it is positioned.

3. Method according to Claim 2, **characterized in that** the electronic assembly (3) comprises a closure (5) with an integrated connector slot (6) for sealing the housing (2).

4. Method according to one of the preceding claims, **characterized in that** the heat conducting medium (16) is positioned on the electronic assembly (3), in particular on a printed circuit board (4) of the electronic assembly (3).

5. Method according to Claim 4, **characterized in that** the heat conducting medium (16) is positioned on the electronic assembly (3) before the electronic assembly (3) is pushed in.

6. Method according to one of the preceding claims, **characterized in that** the heat conducting medium (16) is positioned on an inner surface of the housing (2).

7. Method according to one of the preceding claims, **characterized in that**, for introducing the heat conducting medium (16) into the gap (11), the housing (2) is tilted, so that the heat conducting medium (16) flows into the gap as a result of gravitational force and/or is set in rotation and/or is linearly accelerated.

8. Method according to one of the preceding claims, **characterized in that**, while it is being introduced, the viscosity of the heat conducting medium (16) is reduced by heating and/or vibration of the housing (2) .

9. Method according to one of the preceding claims, **characterized in that** at least one spacer (15) is positioned in the gap (11) between the electronic assembly (3) and at least one of the groove walls (12) .

10. Method according to Claim 9, **characterized in that** the spacers (15) are formed as solder bumps on the electronic assembly (3).

## Revendications

1. Procédé de fabrication d'un appareil de commande (1) comprenant les étapes consistant à :
- prévoir un boîtier (2), dans lequel au moins une rainure (9) présentant deux parois de rainure opposées (12) est formée dans le boîtier (2),
- insérer un ensemble électronique (3) dans le boîtier (2), dans lequel l'ensemble électronique (3) est inséré au moins partiellement dans la rainure (9), et dans lequel il reste un interstice (11) entre l'ensemble électronique (3) et au moins une des parois (12) de la rainure (9),
- positionner un fluide caloporteur liquide (16) à l'extérieur de l'interstice (11) dans l'espace intérieur du boîtier (2),
**caractérisé en ce que** l'introduction du fluide caloporteur (16) dans l'interstice (11) s'effectue par basculement et/ou déplacement du boîtier (2) avec un ensemble électronique (3) inséré, de sorte que le fluide caloporteur (16) s'écoule dans l'interstice (11) et/ou soit entraîné par action capillaire dans l'interstice (11) .

2. Procédé selon la revendication 1, **caractérisé en ce que** le boîtier (2) est fermé de manière étanche aux fluides avant que le fluide caloporteur (16) ne soit introduit dans l'interstice et après qu'il a été positionné.

3. Procédé selon la revendication 2, **caractérisé en ce que** l'ensemble électronique (3) comprend un obturateur (5) muni d'un coulisseau enfichable (6) intégré pour fermer le boîtier (2).

4. Procédé selon l'une des revendications précédentes, **caractérisé en ce que** le fluide caloporteur (16) est positionné sur l'ensemble électronique (3), en particulier sur une carte de circuit imprimé (4) de l'ensemble électronique (3).

5. Procédé selon la revendication 4, **caractérisé en ce que** le fluide caloporteur (16) est positionné sur l'ensemble électronique (3) avant d'insérer l'ensemble électronique (3).

6. Procédé selon l'une des revendications précédentes, **caractérisé en ce que** le fluide caloporteur (16) est positionné sur une surface intérieure du boîtier (2) .

7. Procédé selon l'une des revendications précédentes, **caractérisé en ce que** le boîtier (2) est incliné dans l'interstice (11) pour introduire le fluide caloporteur (16), de sorte que le fluide caloporteur (16) s'écoule dans l'interstice et/ou soit mis en rotation et/ou soit accéléré de manière linéaire par gravité.

8. Procédé selon l'une des revendications précédentes, **caractérisé en ce que** la viscosité du fluide caloporteur (16) est réduite par chauffage et/ou par vibration du boîtier (2) pendant l'introduction.

9. Procédé selon l'une des revendications précédentes, **caractérisé en ce qu'**au moins une entretoise (15) est positionnée dans l'interstice (11) entre l'ensemble électronique (3) et au moins l'une des parois (12) de la rainure.

10. Procédé selon la revendication 9, **caractérisé en ce que** les entretoises (15) sont réalisées sous la forme de bosses de soudure sur l'ensemble électronique (3) .
